# EUROPEAN PATENT APPLICATION

(11) **EP 1 452 876 A1**
(43) Date of publication of application: **01.09.2004**
(21) Application number: 04251021.4
(22) Date of filing: 25.02.2004
(51) Int. Cl.: G01R 13/28

(54) **Simultaneous presentation of locally acquired and remotely acquired waveforms**

(30) Priority: 25.02.2003 US 374872
(71) Applicant: Tektronix, Inc., Beaverton, OR 97077-0001 (US)
(72) Inventor: Zocchi, Donald A., Beaverton, Oregon 97008 (US)
(74) Representative: Burke, Steven David

(57) **Abstract**

A primary test and measurement device merges a primary (i.e., local) a non-primary (i.e., remote) waveform data to produce a display signal that, when presented on a display device, shows both waveforms. The primary measuring device may utilize respective transparent windows for each waveform such that the transparent windows may be overlaid during presentation to display waveform data from the non-primary measuring devices upon the primary measuring device. In this manner, a plurality of test and measurement devices are used to provide a single combined image for presentation.

## Description

### FIELD OF THE INVENTION:

The invention relates generally to signal analysis instruments and, more specifically, to a system, apparatus and method for combining data from multiple signal acquisition instruments for presentation on one instrument.

### BACKGROUND OF THE INVENTION

Signal acquisition devices such as digital storage oscilloscopes (DSOs) and other test and measurement instruments typically include a plurality of input channels for acquiring signals under test (SUT) for subsequent processing and presentation on a display device. DSOs may also include data output ports such that a computer or workstation may acquired data from a plurality of DSOs for subsequent processing and/or display. Unfortunately, such workstation processing and/or display is relatively expensive, complex and, often, cannot be performed in a substantially real-time manner.

### SUMMARY OF INVENTION

These and other deficiencies of the prior art are addressed by the present invention. Specifically, in an embodiment of the invention, a primary test and measurement device such as a DSO acquires one or more signals under test which are then processed to provide waveform data having appropriate time per division and volts per division characteristics for display. The primary test and measurement device receives, via a communications link, waveform data provided by at least one non-primary test and measurement devices. The primary test and measurement device merges the primary (i.e., local) and non-primary (i.e., remote) waveform data to produce a display signal that, when presented on a display device, shows all of the waveforms. The primary measuring device may utilize respective transparent windows for each waveform such that the transparent windows may be overlaid during presentation to display only waveform data from the non-primary measuring devices. In this manner, a plurality of test and measurement devices are used to provide a single combined image for presentation.

In an alternate embodiment of the invention, each of the primary and secondary test and measurement devices are trigger in the synchronized manner using an external trigger controller.

In an alternate embodiment of the invention, rather than being overlaid, the transparent windows including waveforms associated with the respective test and measurement devices are vertically or horizontally compressed such that a mosaic display of the waveforms is provided.

### BRIEF DESCRIPTION OF THE DRAWINGS

The teachings of the present invention can be readily understood by considering the following detailed description in conjunction with the accompanying drawings, in which:
FIG. 1 depicts a high level block diagram of a signal analysis system according to an embodiment of the invention;
FIG. 2 depicts a high level block diagram of a controller suitable for use in the signal analysis system of FIG. 1;
FIG. 3 depicts a flow diagram of a method according to an embodiment of the present invention;
FIGS. 4 and 5 provide graphical representations of oscilloscope display outputs useful in understanding the present invention; and
FIG. 6 graphically depicts layered oscilloscope imagery useful in understanding the present invention.

To facilitate understanding, identical reference numerals have been used, where possible, to designate identical elements that are common to the figures.

### DETAILED DESCRIPTION OF THE INVENTION

The subject invention will be primarily described within the context of a signal acquisition system having a plurality of test and measurement devices such as digital storage oscilloscopes (DSOs) acquiring respective signals under test for display upon a single display device. However, it will be appreciated by those skilled in the art that the invention may be advantageously employed in any environment where multiple signal acquisition and/or analysis devices are desired to process signals under test and to provide a common display of the processed signals. It will be further appreciated by those skilled in the art that where a primary test and measurement device including a display device is utilized for such display, the non-primary test and measurement devices do not need to include respective display devices.

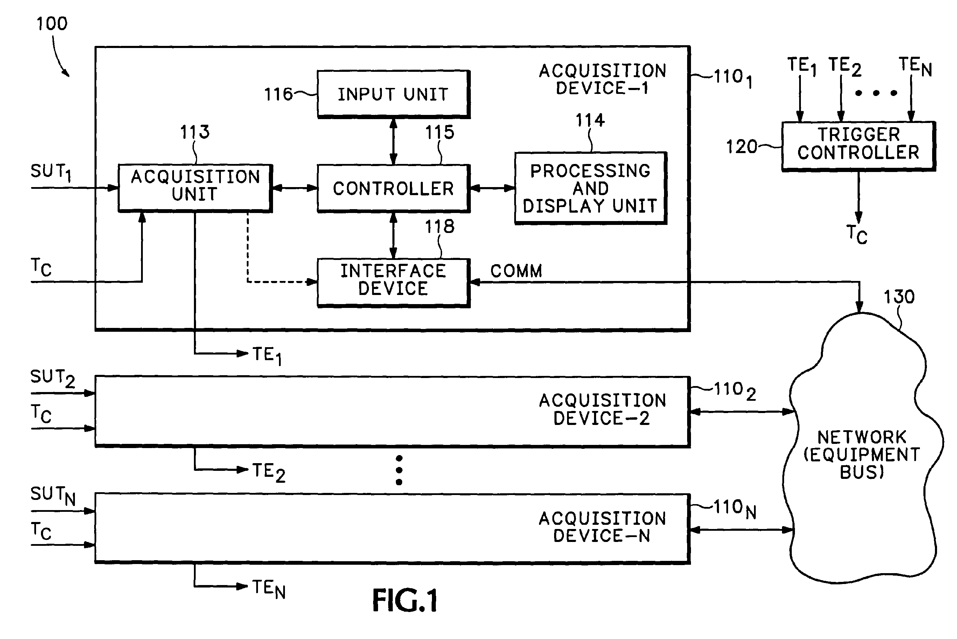

FIG. 1 depicts a high level block diagram of a system according to an embodiment of the present invention. Specifically, the system 100 of FIG. 1 comprises a plurality of signal acquisition devices (e.g., test and measurement instruments) such as digital storage oscilloscopes (DSOs), logic analyzers and the like denoted as acquisition devices 110₁, 110₂ and so on up to 110_{N} (collectively acquisition devices 110). A communications link such as a local area network or equipment bus 130 (e.g., Ethernet, general purpose instrument bus (GPIB), serial communications link, parallel communications link and the like) enables communications between at least a primary acquisition device (e.g., acquisition device 110₁) and at least one non-primary acquisition device. An optional trigger controller 120 provides a trigger control signal T_{C} in response to optional trigger enable signals TE provided by one or more of the acquisition devices 110. The optional trigger controller 120 enables synchronized triggering of the acquisition devices 110 after respective trigger enable conditions within the acquisition devices 110 have occurred.

Each of the acquisition devices 110 comprises, illustratively, a four channel DSO, though more or fewer channels may be used for any or all of the acquisition devices 110. Moreover, more or fewer acquisition devices may be used and, in various embodiments, different types of acquisition devices may be used (e.g., logic analysis). Each of the acquisition devices 110 comprises an acquisition unit 113, a processing and display unit 114, a controller 115, an input unit 116 and an interface device 118. In alternate embodiments, only a primary acquisition device (e.g., acquisition device 110₁) includes a processing and display unit 114 whereas non-primary acquisition devices (e.g., acquisition devices 110₂ through 110_{N}) do not include (or optionally include) respective processing and display units 114.

The acquisition unit 113 comprises, illustratively, analog-to-digital conversion circuitry, triggering circuitry, decimator circuitry, supporting acquisition memory and the like. The acquisition unit 113 operates to digitize at a sample rate S one or more of the signals under test to produce one or more respective acquired sample streams suitable for use by the controller 115 and/or the processing and display unit 114. The acquisition unit 113, in response to commands received from the controller 115, changes trigger conditions, decimator functions and other acquisition related parameters. The acquisition unit communicates the acquired sample stream(s) to the controller 115 for further processing and, optionally, to the interface device 118 for propagation to other acquisition devices 110.

The controller 115 operates to process the one or more acquired sample streams provided by the acquisition unit 113 to generate respective waveform data associated with the one or more sample streams. That is, given desired time per division and volts per division display parameters, the controller 115 operates to modify the raw data associated with an acquired sample streams to produce corresponding waveform data having the desired time per division and volts per division parameters. The controller 115 may also normalize waveform data having non-desired time per division and volts per division parameters to produce waveform data having the desired parameters. The controller 115 provides the waveform data to the processing and display unit 114 for subsequent presentation on the display device.

The processing and display unit 114 comprises data processing circuitry suitable for converting acquired sample streams or waveform data into image or video signals adapted to provide visual imagery (e.g., video frame memory, display formatting and driver circuitry and the like). The processing and display unit 114 may include a display device (e.g., a built in DSO display device) and/or provide output signals (e.g., via a video driver circuit) suitable for use by an external display device. The processing and display unit 114 is optionally responsive to the controller 115 to set various parameters such as vertical (e.g., volts per division) and horizontal (e.g. time per division) display parameters, as well as user interface imagery (e.g., user prompts, diagnostic information and the like). It will be appreciated by those skilled in the art that within the context of a data acquisition system utilizing many acquisition devices 110, it is not necessary to include a processing and display unit 114 in each of the acquisition devices. Moreover, in the case of acquisition devices 110 comprising modules or cards inserted within a computing device or arranged using a back plane, a single processing and display unit 114 may provide an image processing function for any one (or more) of the acquisition devices 110.

The input unit 116 comprises a keypad, pointing device, touch screen or other means adapted to provide use input to the controller 115. The controller 115, in response to such user input, adapts the operations of the acquisition device 110 to perform various data acquisition, triggering, processing, display, communications and/or other functions. In addition, the user input may be used to trigger automatic calibration functions and/or adapt other operating parameters of a DSO, logic analysis or other data acquisition device. Such input may also be provided to the controller 115 via a communications link 130 operably coupled to the interface device 118.

The controller 115 and/or processing and display unit 114 operate to perform a normalization function and a display function with respect to the various waveforms. Moreover, the controller 115 and interface device 118 operate together to perform a communications function which, in the case of a primary acquisition device, requests and receives waveform representative data from the non-primary acquisition devices. In the case of non-primary acquisition devices, their respective controllers 115 and interface devices 118 form respective communication modules that interact with at least the primary acquisition device to receive and respond to requests for waveform data provided by the primary acquisition device.

It will be appreciated by those skilled in the art that standard signal processing components (not shown) such as signal buffering circuitry, signal conditioning circuitry and the like are also employed as appropriate to enable the various functions described herein. For example, the acquisition unit 113 samples the signals under test at a sufficiently high rate to enable appropriate processing by the controller 115 and/or processing and display unit 114.

In one embodiment, the acquisition unit 113 provides a trigger enable signal TE to an optional trigger controller 120. The trigger enable signal TE is asserted in response to a determination by circuitry within the acquisition unit 113 that a desired triggering event such as a particular sequence of logic levels indicative of a portion of a data word or the like has been received via the signals under test. The desired triggering event(s) may comprise any combinatorial and/or sequential logic function applied to the signals under test received by the acquisition unit 113. The specific triggering event(s) are supplied to the acquisition unit 113 via the controller 115.

The external trigger controller 120 processes the received trigger signals TE₁ through TE_{N} provided by the acquisition devices 110₁ through 110_{N} to determine whether a desired combined trigger condition is met. Such processing may comprise any combinatorial and/or sequential logic processing of the trigger enable signals, such as conventional logic processing (AND, NAND, XOR, etc.). In response to the satisfaction of the desired combined trigger condition, the external trigger controller 120 produces a trigger control signal T_{C} having a defined state, logic level, waveform and the like which is coupled to one or more of the data acquisition devices 110. The trigger control signal T_{C} is provided to respective acquisition units 113, which responsively acquire at least portions of their respective received signals under test.

The combined trigger event enabled by the trigger controller 120 may be used to trigger each of the multiple instruments and, thereby, synchronize operation of the instruments. That is, by operating the various signal acquisition devices 110 in a synchronized manner, the acquired signals under test generated by the acquisition units 113 of the acquisition devices 110 have a known temporal relationship to each other. In alternate embodiments of the acquisition devices 110, acquisition times between instruments having different operational parameters (e.g., acquisition speed, acquisition rate, record length, hold-off time, processing time and the like) are adapted to enable a relatively synchronized data acquisition process across multiple instrument platforms such that resulting acquired data from the various channels and the various instruments may be usefully synchronized and otherwise processed.

Exemplary embodiments of synchronized triggering of multiple data acquisition devices 110, including associated signal acquisition, trigger decode, trigger control and signal routing functions are described in more detail in U.S. Patent Applications Nos. (Attorney Docket No. TKTX/7283US) and (Attorney Docket No. TXTX/7324US), which are commonly assigned to Tektronix Corporation of Beaverton, Oregon, were simultaneously filed on and are incorporated herein by reference in their respective entireties.

In a test and measurement system according to an embodiment of the invention, one of the acquisition devices 110 (illustratively first acquisition device 110₁) is denoted as a primary acquisition device while at least one other acquisition device 110 (illustratively second acquisition device 110₂) is denoted as a non-primary acquisition device. The primary acquisition device acquires its respective signals under test (SUT₁), processes the acquired signals under test to provide waveform data having appropriate time per division and volts per division parameters, and displays the waveform data via the processing and display unit 114. Each of the non-primary acquisition devices acquires its respective signals under test, and processes the acquired signals under test to produce waveform data having appropriate time per division and volts per division format. Alternatively, the primary device may perform such a normalization function.

Within the primary acquisition device, the primary acquisition device waveform data and any user interface or other information is displayed within a base window or image layer upon a liquid crystal display (LCD) or other display device within the processing and display unit 114. Alternatively, the processing and display unit 114 may provide image representative signals, such as video signals, which are suitable for driving an external display device (not shown).

The waveform data of the non-primary acquisition devices is provided to the primary acquisition device via the network 130. The primary acquisition device associates each waveform data stream provided by the non-primary acquisition devices with a respective transparent window or image layer which is then "drawn" or superimposed over the base window or image layer. In this manner, waveform data supplied by multiple acquisition devices is simultaneously displayed via the primary acquisition device.

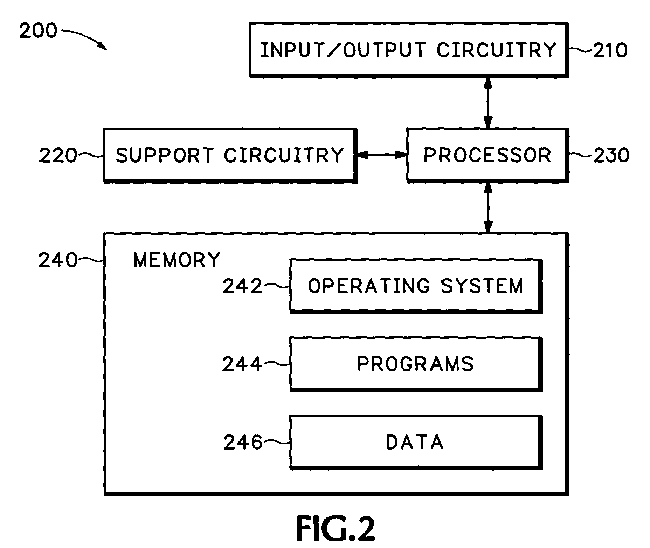

FIG. 2 depicts a high level block diagram of a controller suitable for use in the signal analysis system of FIG. 1. Specifically, the controller 200 of FIG. 2 may be employed to implement functions of the controller 115. The controller 200 may also be used to implement various functions within the acquisition units 113, processing and display units 114, input unit 116 and/or interface device 118 either individually or in any combination.

The controller 200 of FIG. 2 comprises a processor 230 as well as memory 240 for storing various control programs and other programs 244 and data 246. The memory 240 may also store an operating system 242 supporting the programs 244, such as the Windows® operating system manufactured by Microsoft Corporation of Redmond, Washington. Within the context of the Windows operating system, the Microsoft .NET framework may be utilized in various embodiments of the invention which will be discussed below in more detail. Other operating systems, frameworks and environments suitable for performing the tasks described herein will also be appreciated by those skilled in the art and informed by the teachings of the present invention. For example, the Apple® Macintosh® operating systems, the various Unix-derived operating systems and the like also support functions including data retrieval and display functions useful in practicing the present invention.

The processor 230 cooperates with conventional support circuitry such as power supplies, clock circuits, cache memory and the like as well as circuits that assist in executing the software routines stored in the memory 240. As such, it is contemplated that some of the steps discussed herein as software processes may be implemented within hardware, for example as circuitry that cooperates with the processor 230 to perform various steps. The controller 200 also contains input/output (I/O) circuitry 210 that forms an interface between the various functional elements communicating with the controller 200. Although the controller 200 is depicted as a general purpose computer that is programmed to perform various control functions in accordance with the present invention, the invention can be implemented in hardware as, for example, an application specific integrated circuit (ASIC) or field programmable gate array (FPGA). As such, the process steps described herein are intended to be broadly interpreted as being equivalently performed by software, hardware or a combination thereof.

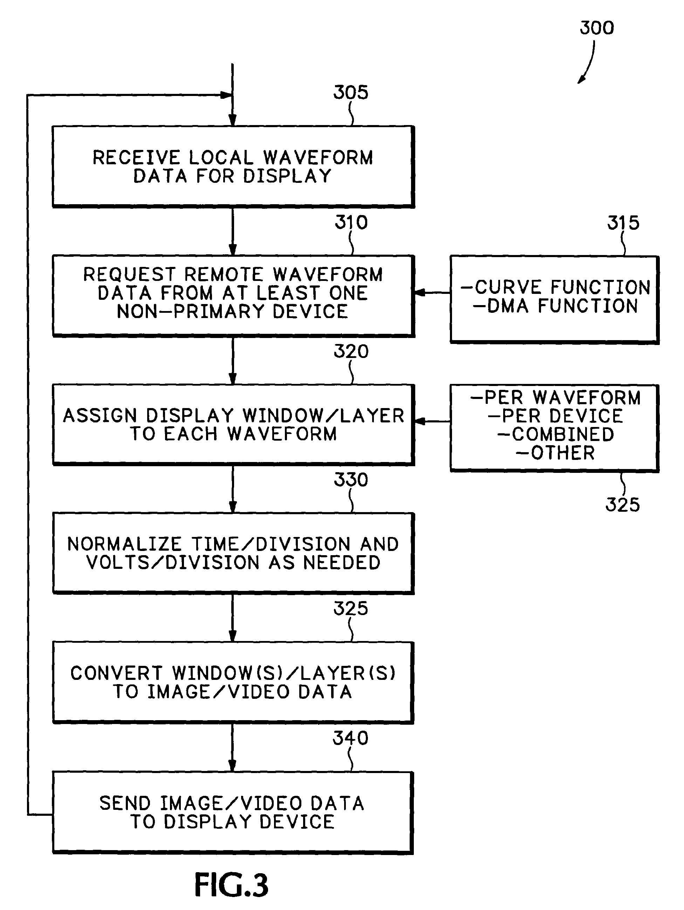

FIG. 3 depicts a flow diagram of a method according to an embodiment of the present invention. Specifically, the method 300 of FIG. 3 describes processing functions occurring within a primary acquisition device such as discussed above with respect to FIG. 1.

At step 305, local waveform data is received for display. That is, waveform data produced by the controller 115 in response to the acquired data streams provided by the acquisition unit 113 is provided to the processing and display unit 114 for display or inclusion within a displayable video or image stream. The local waveform data represents waveform data within a first or primary window or image layer. This first or primary window or image layer may also include graticule and other formatting information, user information, user messages and the like. Essentially, in one embodiment of the invention, the waveform data received at step 305 comprises the waveform data normally associated with an output image produced by, for example, a conventional DSO.

At step 310, a request for remote waveform data from at least one non-primary device is made. That is, referring to box 315, the "curve" query supported by the Microsoft .NET framework, a "retrieve data" function call, a direct memory access (DMA) function or other command appropriate for requesting waveform data from at least one non-primary device is invoked.

At step 320, a display window/layer is assigned to each waveform data stream received by the primary signal acquisition device. That is, for each of the waveform data streams provided by the non-primary acquisition devices, a respective transparent window or image layer is assigned. Per box 325, a transparent window or image layer may be assigned on a per waveform basis, a per device basis (one window per non-primary acquisition device), a combination of per waveform and per device or other assignment (e.g., all clock signals in one window, all data signals in another window).

In one embodiment of the invention, a mathematical function (or any transfer or transform function) such as a filtering, domain transform or other function is performed using locally acquired data, remotely acquired data or a combination thereof. The data so processed may comprise raw acquisition data, waveform data and/or normalized waveform data, In this embodiment, a transparent window or image layer is assigned to display the output waveform or processed data generated by the mathematical function over, for example, one or more of the underlying waveforms processed by the mathematical function. In this embodiment, the various mathematical manipulations and/or processing may be performed by a processing module comprising the functionality of the acquisition unit 113, controller 115 and/or processing and display unit 114.

At step 330, the time per division and volts per division are normalized as needed. That is, at step 330, the controller 115 of the primary acquisition device operates to insure that each of the waveforms to be displayed has been normalized to a common time per division display format and volts per division display format. In this manner, when superimposing the various windows or image layers including waveform data, the resulting display including multiple superimposed waveforms will have meaning to a viewer of the test instrument.

At step 335, the transparent windows/image layers are converted to image or video data. That is, at step 335, at least one of the controller 115 and processing and display unit 114 convert the waveform representative window/layer data into image/video data. For example, each transparent window includes a waveform portion and a background portion, where the background portion is caused to be transparent. The data used to represent each window is merged together such that the resulting merged display window is provided including all of the waveform portions. This image is converted into, for example, a video signal for display by a video driven display device. Alternatively, the resulting merged frame is stored in a frame store memory which is accessed by a display device during a frame draw or display procedure.

At step 340, the image/video data is sent to the display device for subsequent presentation.

The above-described method 300 of FIG. 3 describes the creation and presentation of a single image frame comprising waveform data provided by a primary acquisition device and at least one non-primary acquisition device for a given period of time. As such, the method 300 of FIG. 3 is continually repeated such that a substantially continuous display of waveform imagery is provided. The temporal segmentation of waveform data for display purposes may be controlled by either of the controller 115 or processing and display unit 114.

The above-described method 300 of FIG. 3 is primarily shown and described as a single process comprising the repetition of steps 305-340 in sequence. However, the method 300 of FIG. 3 may also be implemented as two relatively disconnected processes. Specifically, a first process comprises displaying locally generated or acquired waveforms, while a second process comprises retrieving and displaying remotely generated waveforms and/or acquired sample streams. These two processes may be operated in a concurrent manner.

In one embodiment of the invention, the primary acquisition device performs all normalization or other processing necessary to adapt the time per division and/or volts per division parameters of the waveform data supplied by the non-primary acquisition devices. In this embodiment of the invention, the primary acquisition device receives waveform data from a non-primary acquisition device along with an indication of the time base associated with the waveform data. The time base indication may comprise data specifically defining the time per division (and/or volts per division) information associated with the waveform, a clock signal indicative of the sampling rate S used to produce the acquired data within the waveform, a default time base and the like. The primary acquisition device then normalizes the received or "remote" waveform data to the "local" waveform data initially generated by the primary acquisition device. Each of the various waveform data streams or data structures is then associated with a respective transparent window or image layer and simultaneously displayed.

In one embodiment of the invention, each non-primary acquisition device supplies waveform data from multiple acquired signals under test for inclusion in a single respective transparent window or image layer. Alternatively, the waveform data associated with each acquired signal under test is associated with a unique transparent window or image layer, such that each signal under test acquired by the non-primary acquisition device is associated with a single unique transparent window or image layer.

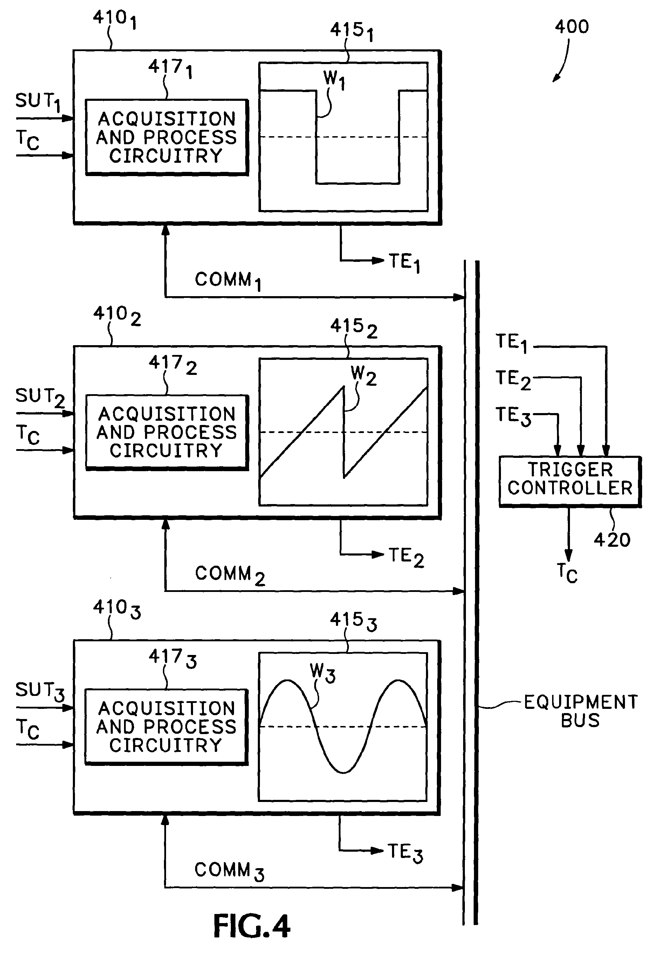

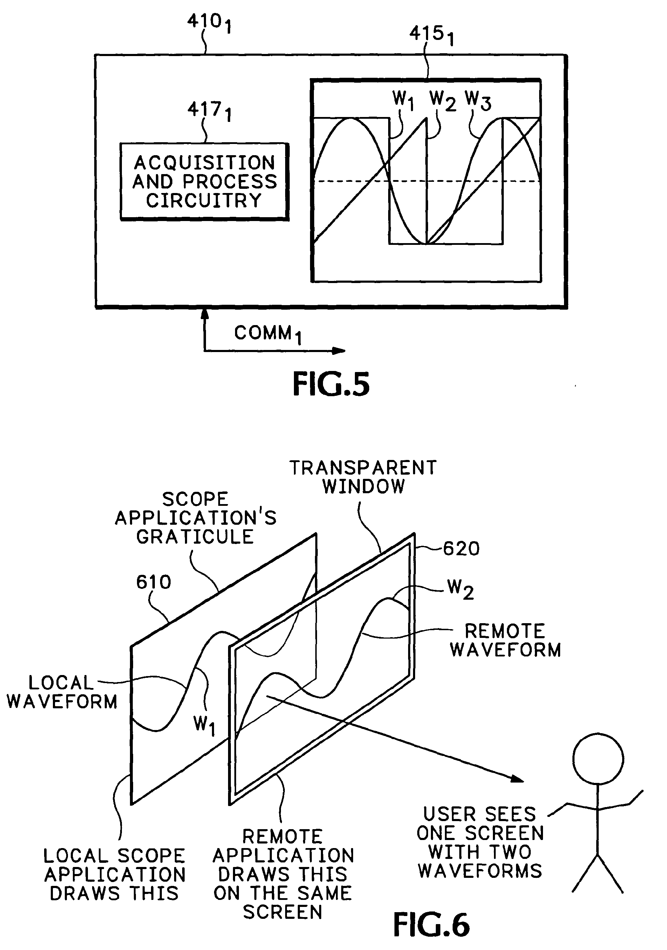

FIGS. 4 and 5 provide graphical representations of oscilloscope display outputs useful in understanding the present invention. Specifically, FIG. 4 depicts a testing system 400 in which a plurality of oscilloscopes 410₁ through 410₃ (collectively oscilloscopes 410) are provided. Each of the oscilloscopes 410 comprises respective acquisition and processing circuitry 417 as well as a display device 415. Each of the oscilloscopes 410 receives a respective signal under test (SUT) which is acquired and processed by the acquisition and processing circuitry 417 to produce a respective waveform W for display on the respective display device 415. Each of the oscilloscopes 410 communicates with an equipment bus via a respective communications link COMM. In this manner, a primary oscilloscope (e.g., oscilloscope 410₁) is able to retrieve waveform data from each of the non-primary acquisition devices (e.g., oscilloscopes 410₂ and 410₃). The primary oscilloscope 410₁ then displays upon its display device 415₁ the waveforms W₁, W₂ and W₃ generated by each of the three oscilloscopes 410. This multiple waveform display will be discussed in more detail below with respect to FIGS. 5 and 6.

In a controlled trigger mode of operation, each of the oscilloscopes 410 produces a respective trigger enable signal TE in the manner previously described with respect to FIG. 1. A trigger controller 420 operates in the manner described above with respect to trigger controller 120 of the system 100 of FIG. 1 to produce a trigger control signal T_{C} in response to appropriate conditions of the three trigger enable signals TE₁, TE₂ and TE₃. That is, each oscilloscope 410 synchronizes its respective triggering function to the trigger control signal T_{C}, such that the resulting waveforms W₁, W₂ and W₃ comprise temporally synchronized waveforms. Thus, while the testing system 400 is extremely useful in synchronizing the operation of multiple testing devices such as the oscilloscopes 410, the present invention augments the utility of the system 400 by enabling simultaneous display of each of the waveforms W₁, W₂ and W₃ upon a single display device.

FIG. 5 depicts a graphical representation of the simultaneous display of waveforms acquired within, for example, the context of the system 400 of FIG. 4. For purposes of this discussion, it will be assumed that the first oscilloscope 410₁ comprises a primary acquisition device while the second 410₂ and third 410₃ oscilloscopes comprise non-primary acquisition devices. Specifically, FIG. 5 depicts the primary acquisition device 410₁ of FIG. 4 comprising the respective display region 415₁ and acquisition and processing circuitry 417₁. The equipment bus communications link COMM₁ of the primary acquisition device 410₁ is used to retrieve waveform data from each of the non-primary acquisition devices 410₂ and 410₃. Each of the retrieved non-primary device waveforms W₂ and W₃ are associated with a respective transparent layer by the primary acquisition device 410. The transparent layers are superimposed upon an image layer including the primary acquisition device waveform W₁ and, optionally, other information provided within the context of an oscilloscope display (e.g., graticule information, mathematical function information, user interface information and the like). As shown in FIG. 5, the first waveform W1 (a square wave) has superimposed over it the second waveform W2 (a ramp function) and a third waveform W3 (a sine wave).

FIG. 6 graphically depicts layered oscilloscope imagery useful in understanding the present invention. Specifically, FIG. 6 displays a primary acquisition device oscilloscope application graticule 610 including a local waveform W₁. Superimposed upon the locally drawn waveform W₁ is a transparent window 620 including a remote waveform W₂ which, when viewed by a user, is seen as two waveforms W₁ and W₂ drawn in respective superimposed windows within a single window region of a display device. It will be appreciated by those skilled in the art that more or fewer transparent windows may be used, and that more or fewer local and/or remote waveforms may be disposed within their respective windows. As discussed above, synchronized triggering is useful (though not necessary) within the context of the present invention to provide local and remote waveforms having some meaning with respect to each other such that a user analyzing the waveforms may derive useful information from the layered display presented herein.

In one embodiment of the invention, multiple digital storage oscilloscopes are used within the context of a test and measurement system. Each of the oscilloscopes operates in a conventional manner to capture, process and display local waveforms. However, an additional program comprising a .NET application is added to the programs 244 operating on the first oscilloscope. The additional program continuously requests waveforms from the second oscilloscope using a CURVE? query, normalizes the received waveforms to fit the display parameters of the first oscilloscope, associates each of the waveforms with a respective window or image layer having a transparent background, and simultaneously displays all the waveform bearing windows or image layers. (As known to those skilled in the art, the term "CURVE?" query refers to an interrogation command of predetermined format which is recognised by certain types of oscilloscopes and which causes those oscilloscopes to return data representative of waveforms.)

By adding the above-described .NET application to the existing oscilloscope application program of the first oscilloscope, the remote waveform retrieval, normalization and display function is integrated into the first oscilloscope operation in a substantially seamless manner. In this example, a transparency key within the operating or display system is associated with a specific color (e.g., navy blue or dark gray) which is also used as the background color for at least the non-primary waveform windows. In this manner, any time the specific color is to be drawn the resulting imagery is not drawn (i.e., the color is invisible). By providing a window for each waveform to be drawn where the window includes a background color set to the transparency key color value, the resulting background portions of the window are not drawn and a plurality of waveform windows may be simultaneously displayed.

In one embodiment, a test and measurement device such a digital storage oscilloscope (DSO) includes nominal software and additional software. The nominal software comprises the instructions stored in memory that, when executed, enable the standard DSO functions of signal acquisition, processing and display. Within this context, the nominal software operates to produce a conventional DSO display. The additional software, such as the above-described .NET framework addition, comprises the instructions stored in memory that, when executed, enable the additional functions described herein with respect to the present invention. That is, a conventional DSO software environment is augmented by an additional software module capable of at least one of the following functions: requesting remote waveform and/or acquisition data, receiving remote waveform and/or acquisition data, processing remote waveform and/or acquisition data to provide windowed of image layered representations having appropriate display parameters (as discussed in more detail above), causing the remotely derived waveform data to be displayed using transparent background windows or image layers (if such functionality is not already supported by the nominal software).

The above-described invention is primarily described within the context of waveform representative data and any normalization and display processing steps used to enable the simultaneous display of multiple waveforms. It will be appreciated by those skilled in the art informed by the teachings of the present invention that the "raw" data provided by the acquisition units 113 may also be processed in accordance with the present invention. That is, the non-primary acquisition devices may provide acquired sample streams directly from their respective acquisition units 113, rather than waveform data which has been processed by their controller 115 and/or processing and display unit 114. In this embodiment, the controller 115 and/or processing and display unit 114 of the primary acquisition device will convert the acquired sample streams into respective waveforms having combined or respective windows or image layers for subsequent presentation.

While the foregoing is directed to the preferred embodiment of the present invention, other and further embodiments of the invention may be devised without departing from the basic scope thereof, and the scope thereof is determined by the claims that follow.

## Claims

1. A method for use in a test and measurement instrument, comprising:
associating, with a first display window, first waveform data derived from a locally acquired signal under test (SUT);
associating, with a second display window, second waveform data derived from a remotely acquired SUT, said second display window having a transparent background display property;
generating an image signal adapted for use by a display device to produce imagery comprising said second display window superimposed over said first display window.

2. The method of claim 1, further comprising:
retrieving, from a remote acquisition device, said second waveform data.

3. The method of claim 1, further comprising:
retrieving, from a remote acquisition device, a stream of samples of said remotely acquired SUT; and
converting said stream of samples into said second waveform data.

4. The method of claim 1, further comprising:
normalizing timing and amplitude parameters of said waveform data.

5. The method of claim 2, wherein:
said retrieving comprises invoking a "CURVE?" query.

6. The method of claim 1, wherein:
said locally and remotely acquired SUT are acquired in a substantially synchronized manner.

7. The method of claim 6, further comprising:
generating a trigger enable signal suitable for use by an external trigger controller processing corresponding trigger enable signals produced by each of a plurality of signal acquisition devices.

8. The method of claim 1, further comprising:
processing at least one of said first and second waveform data according to a predefined function to produce thereby processed waveform data; and
associating said processed waveform data with a third display window, said third display window having a transparent background display property;

9. The method of claim 8, wherein:
said predefined function comprises a filtering function;
said third display window displaying filtered waveform data produced according to said filtering function.

10. A test and measurement system, comprising:
a first signal acquisition device comprising a signal acquisition module and a communications module, said signal acquisition module acquiring at least a first signal under test (SUT), said communications module providing waveform representative data of said acquired first SUT to a communications link; and
a second signal acquisition device comprising a signal acquisition module, a communications module and a display module, said signal acquisition module acquiring at least a second SUT, said communications module receiving said waveform representative data of said acquired first SUT from said communications link, and said display module generating a display signal including waveform representative data of said at least first acquired SUT and said at least second acquired SUT.

11. The system of claim 10, wherein:
said acquisition modules within said first and second signal acquisition devices utilize a common trigger signal to acquire respective signals under test.

12. The system of claim 10, further comprising:
a third signal acquisition device comprising a signal acquisition module and a communications module, said signal acquisition module acquiring at least a third SUT, said communications module providing waveform representative data of said acquired third SUT to a communications link;
said display signal generated by said display module of said second signal acquisition device further including waveform representative data of said at least third acquired SUT.

13. The system of claim 10, wherein:
said second signal acquisition device utilizing a transparency function to overlay waveform representative data of said at least first acquired SUT and said at least second acquired SUT.

14. The system of claim 10, wherein:
said second signal acquisition device further comprising a signal processing module for processing at least one of said at least first acquired SUT and said at least second acquired SUT according to a predefined function to produce thereby processed waveform data;
said second signal acquisition device utilizing a transparency function to overlay said processed waveform data and at least one of said at least first acquired SUT and said at least second acquired SUT.

15. The system of claim 14, wherein:
said predefined function comprises a filtering function.

16. A test and measurement instrument, comprising:
an acquisition module, for acquiring a first signal under test (SUT) to produce a first sample stream;
a processing module, for modifying at least one of a timing parameter and an amplitude parameter associated with said first sample stream to produce waveform representative data of said first sample stream;
a communications module, for receiving waveform representative data of a second sample stream from a communications link; and
a display module, for generating a display signal that, when displayed on a display device, produces imagery including superimposed waveforms of said first and second sample streams.

17. The instrument of claim 16, wherein:
said processing module normalizes timing and amplitude parameters associated with said second sample stream waveform representative data to timing and amplitude parameters associated with said first sample stream waveform representative data.

18. The instrument of claim 16, wherein:
said communications module receives waveform representative data of at least a third sample stream from said communications link; and
said display module includes within said display signal imagery from said waveform representative data of at least a third sample stream.

19. The instrument of claim 18, wherein:
said processing module normalizes timing and amplitude parameters associated with said second and at least third sample stream waveform representative data to timing and amplitude parameters associated with said first sample stream waveform representative data.

20. The instrument of claim 16, wherein:
said waveform representative data of said second sample stream is produced by a processing module within a second test and measurement instrument in response to a SUT acquired by an acquisition module within said second test and measurement instrument.

21. The instrument of claim 16, wherein:
said instrument comprises a digital storage oscilloscope (DSO) including nominal software and additional software; said nominal software providing a nominal functionality to said DSO
